# EUROPEAN PATENT APPLICATION

(11) **EP 1 158 576 A2**
(43) Date of publication of application: **28.11.2001**
(21) Application number: 01112800.6
(22) Date of filing: 28.05.2001
(51) Int. Cl.: H01L 21/311, H01L 21/00, C04B 41/53, H01L 21/316, C23F 4/00

(54) **Method for etching a compound metal oxide film and processing apparatus**

(30) Priority: 26.05.2000 JP 2000157004
(71) Applicant: Tokyo Electron Limited, Tokyo-to (JP)
(72) Inventor: Yamamoto, Hiroyuki, c/o Tokyo Electron Tohoku Ltd., Machi, Tsukui-Gun, Kanagawa-Ken (JP); Nishimura, Kazuaki, c/o Tokyo Electron Tohoku Ltd., Machi, Tsukui-Gun, Kanagawa-Ken (JP); Hasebe, Kazuhide, c/o Tokyo Electron Ltd., Yamanashi-Ken (JP); Spaull, Phillip, c/o Tokyo Electron Tohoku Ltd., Machi, Tsukui-Gun, Kanagawa-Ken (JP)
(74) Representative: Liesegang, Roland, Dr.-Ing.

(57) **Abstract**

The present invention is directed to a method of etching a compound metal oxide film containing plural kinds of metallic element, such as Ba, Sr, Ti or the like. A first cleaning step employing Cl₂ gas is carried out in order to remove alkaline earth metal (Ba, Sr) from the film, then a second cleaning step employing ClF₃ gas is carried out in order to remove a metal (Ti) other than the alkaline earth metal from the film. The etching method is applicable not only to the etching process in the semiconductor manufacturing but also to the cleaning process for cleaning the processing vessel for film deposition.

## Description

### BACKGROUND OF THE INVENTION

### Technical Field of the Invention

The present invention relates to an etching method for etching a compound metal oxide film containing plural kinds of metals such as barium, strontium, titanium, etc, an processing apparatus for depositing a compound metal oxide film on a substrate and an etching apparatus for etching a compound metal oxide film deposited on a substrate.

### Description of the Related Art

Generally, in order to manufacture a semiconductor device, there are repeatedly carried out a film-depositing process and a pattern-etching process to produce a desired semiconductor device. Particularly, in the film-depositing technique, its process specifications, namely, design rules have become severe year by year with the progressed densification and integration for the semiconductor devices. For remarkably thin oxide films, for example, a capacitor-insulation film and a gate-insulation film in the semiconductor device, there exists a requirement to form them thinner together with a requirement of high insulation.

Although a silicon oxide film, a silicon nitride film, etc. are usable as these insulation films, there is a recent tendency to employ metal oxide films as materials exhibiting more superior insulation characteristics, for example, a tantalum oxide film (Ta₂O₅) with the order from 30 to 50 in dielectric constant. More recently, it has been considered to employ compound metal oxide films, as the insulation films, including plural kinds of metals such as: SrTiO₃ (called "STO" hereinafter) having a dielectric constant (the order of 100) larger than that of the tantalum oxide film; and BaₓSr₁₋ₓ TiO₃ (called "BSTO" hereinafter) having a dielectric constant of the order from 200 to 300. The above-mentioned BSTO is also called "BST" in general.

Because of high dielectric constants being higher than those of the silicon oxide film and the tantalum oxide film, these compound metal oxide films are capable of ensuring sufficient capacities despite that the capacitors have tiny areas due to the progressed high integration. Furthermore, as the compound metal oxide films can exhibit insulation of high reliability in spite of thinness of their films, these films are particularly promising as the material for capacitor-insulation film and therefore, it is expected that they will be used more frequently in the future.

It is generally known that, in a film forming apparatus for depositing various kinds of films on a semiconductor wafer, a cleaning process is regularly or irregularly performed in order to remove unnecessary films adhering to the inner face of a processing vessel. As to the cleaning process, there are known a wet cleaning method of cleaning the processing vessel detached from the apparatus by a cleaning liquid, such as acid, and a dry cleaning method of cleaning the processing vessel "in-situ" without being removed from the apparatus by a cleaning gas.

In view of an improvement in throughput of the apparatus, it is preferable to establish the above dry cleaning method. Nevertheless, there is not yet established a dry cleaning method of removing the above-mentioned unnecessary compound metal oxide film without damaging quartz glass forming the processing vessel, in the present circumstances.

In addition, establishment of an effective etching method for etching the compound metal oxide film deposited on a semiconductor wafer is desired.

### SUMMARY OF THE INVENTION

Therefore, the object of the present invention is to provide an effective etching method for etching the compound metal oxide film. The second object of the present invention is to provide an processing apparatus for depositing a compound metal oxide film on a substrate and an etching apparatus for etching a compound metal oxide film deposited on a substrate.

To attain the objective, the present invention provides a method of etching a compound metal oxide film containing a plurality of kinds of metallic elements, the method including the steps of: (i) supplying a first etching gas to the film in order to remove at least one of the metallic elements from the film; (ii) supplying a second etching gas to the film in order to remove at least one of the metallic elements other than the at least one of the metallic elements to be removed in the step (i).

In one embodiment, the at least one of the metallic elements to be removed in the step (i) is an alkaline earth metal, such as Ba, Sr, and the first etching gas is Cl₂-gas, and the at least one of the metallic elements to be removed in the step (ii) is a metal, such as Ti, other than the alkaline earth metal, and the second etching gas is ClF₃-gas.

The above etching method is applicable not only to the etching process in, for example, a semiconductor device fabrication but also to a cleaning process for cleaning a processing vessel of a deposition apparatus or the like.

The present invention also provides a processing apparatus for film deposition, which includes: a processing vessel defining a processing space, in which an object is subjected to a film deposition process; a film deposition gas supply system that supplies a deposition gas into the processing vessel; and a cleaning gas supply system including: a first subsystem that supplies a first cleaning gas into the processing vessel; and a second subsystem that supplies a second cleaning gas into the processing vessel, wherein the cleaning gas supply system is capable of supplying the first and the second cleaning gases selectively.

The present invention further provides an etching apparatus, which includes: a processing vessel defining a processing space, in which an object is subjected to an etching process; an etching gas supply system including: a first subsystem that supplies a first etching gas into the processing vessel; and a second subsystem that supplies a second etching gas into the processing vessel, wherein the etching gas supply system is capable of supplying the first and the second etching gases selectively.

The above and other features and advantages of this invention will become apparent, and the invention itself will best be understood, from a study of the following description and appended claims, with reference had to the attached drawings showing one preferred embodiment of the present invention.

### BRIEF DESCRIPTION OF THE DRAWINGS

Fig. 1 is a structural diagram showing a processing apparatus according to the present invention;
Fig. 2 is a graph showing temperature dependence of respective percent residual content of Sr and Ti, in case of employing Cl₂ gas as a cleaning gas;
Fig. 3 is a graph showing pressure dependence of respective percent residual content of Sr and Ti, in case of employing Cl₂ gas as a cleaning gas;
Fig. 4 is a graph showing temperature dependence of respective percent residual content of Sr and Ti, in case of employing ClF₃ gas as a cleaning gas;
Fig. 5 is a graph showing pressure dependence of respective percent residual content of Sr and Ti, in case of employing ClF₃ gas as a cleaning gas;
Fig. 6 is a table showing an amount of quarts etched off by the cleaning gases;
Fig. 7 is a process diagram showing a film deposition process and a cleaning process.
Fig. 8A to Fig. 8C are cross sectional views for explaining a semiconductor device fabricating process.

### DESCRIPTION OF THE PREFERRED EMBODIMENT

With reference to the attached drawings, an embodiment of a cleaning method and a processing apparatus in accordance with the present invention will be described below.

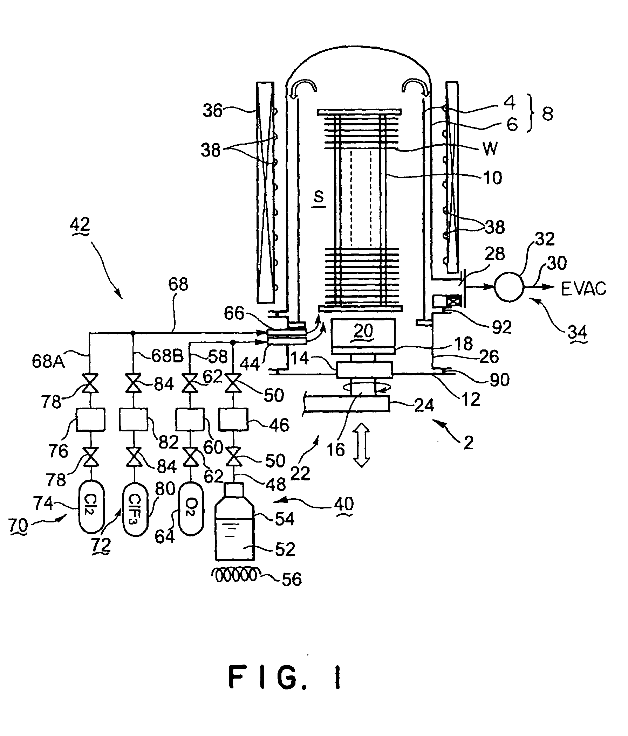

Fig. 1 shows the structure of a processing apparatus capable of carrying out a cleaning method in accordance with the present invention.

The processing apparatus 2 has a processing vessel 8 of vertical type having an inner tube 4 and an outer tube 6, which are arranged to make a double tube structure. Tubes 4 and 6 are made of quarts. Accommodated in a processing space S in the inner tube 4 is a wafer boat 10, which is made of quartz and serves as means for carrying objects to be processed. Semiconductor wafers W are to be carried by the wafer boat 10 at predetermined intervals in multistage. A cap 12 is arranged to open and close a lowermost opening of the processing vessel 8. A rotating shaft 16 penetrates the cap 12 through the magnetic fluid seal 14. On the top end of the rotating shaft 16, there is arranged a rotary table 18 on which a heat-insulating cylinder 20 made of quartz is arranged. The wafer boat 10 is mounted on the heat-insulating cylinder 20. The rotating shaft 16 is attached to an arm 24 of a boat elevator 22, which is capable of vertical movement. Therefore, upon actuating the boat elevator 22, the wafer boat 10 moves vertically, together with the cap 12, the shaft 16, the table 18 and the cylinder 20, allowing the wafer boat 10 to be loaded to and unloaded from the interior of the processing vessel 8 through the lowermost opening thereof. A manifold 26 made of stainless steel is welded to a lowermost portion of the processing vessel 8.

Provided on a bottom sidewall of the outer tube 6 is an exhaust port 28, to which a vacuum exhaust system 34 interposing a vacuum pump 32 in an exhaust path 30 is connected in order to evacuate the interior of the processing vessel 8.

A heat insulating material 36 is provided outside the processing vessel 8. A heater 38, i.e., heating means, is arranged inside the heat insulating material 36 in order to heat the processing vessel 8 and wafers W disposed therein.

Upon assumption that the wafer W to be processed has 8 inches in size and the number of wafers W carried by the wafer boat 10 is the order of 120 pcs. (consisting of products wafers of about 100 pcs and dummy wafers of about 20 pcs.), the diameter of the inner tube 4 is approx. 260 to 270 mm, the diameter of the outer tube 6 approx. 275 to 285, and the height of the vessel 8 is approx. 1,280 mm.

The processing apparatus 2 according to the present invention is further provided with a processing gas (deposition gas) supplying system 40 and a cleaning gas supplying system 42.

Explanation for the processing gas supplying system 40 will be made hereinafter. A processing gas supplying nozzle 44 is arranged at the manifold 26. A distal end of a processing gas passage 48 including a flow controller 46, such as mass flow controller, is connected to the nozzle 44. Open-close valves 50, 50 are arranged on the upstream and downstream sides of the flow controller 46, respectively. A proximal end of the gas passage 48 is connected with a material tank 54, which stores a raw liquid 52 and provided with an evaporating heater 56. The raw liquid 52 is heated and vaporized by an evaporating heater 56, thereby a film deposition gas, i.e., a processing gas is produced.

In case of depositing STO as the compound metal oxide film, there may be employed a raw liquid 52 resulting from dissolving Sr (DPM)₂ and Ti (t-BuO)₂(DPM)₂ (these are organic metallic materials being solid under normal temperature and pressure) into a solvent, such as THF (tetrahydrofuran: C₄H₅O) or butyl acetate, in a designated weight ratio.

Alternatively, in case of depositing BSTO as the compound metal oxide film, there may be employed a raw liquid resulting from dissolving Ba (DPM)₂ (it is an organic metallic material being solid under normal temperature and pressure) into the above raw liquid for STO, in a designated weight ratio. Note, "DPM" represents "dipivaloyle methanate", and "t-BuO" represents "tertial-butoxide". For supplying the film deposition gas, an inert gas, for example, N₂ gas may be used as a carrier gas.

In the above description, the raw liquid 52 is made by dissolving two or three kinds of organic metals into one solvent. However, a plurality of material tanks, each of which accommodates raw liquid made by dissolving one (or two) of the organic metals into a solvent, may be provided, and material gases from respective material tanks may be supplied to the processing vessel 8 under respective flow-controls.

On the downstream side of the downstream side valve 50, a distal end of an oxidation gas passage 58 is connected to the processing gas passage 48. The oxidation gas passage 58 is provided with a flow controller 60 (e.g. mass flow controller) and open-close valves 62, 62. A proximal end of the oxidation gas passage 58 is connected to an oxidation gas source 64, which supplies an oxidation gas, such as oxygen gas. In the modification, the manifold 26 may be provided with another nozzle (other than the nozzle 44) for supplying the oxidation gas into the processing vessel 8 independently from the film deposition gas.

Explanation for the cleaning gas supplying system 40 will be made hereinafter. The cleaning gas supplying system 40 includes a first subsystem 70 for supplying a first cleaning gas and a second subsystem 72 for supplying a second cleaning gas.

A cleaning gas supplying nozzle 66 is arranged at the manifold 26. A distal end of cleaning gas passage 68 is connected to the nozzle 66. The cleaning gas passage 68 is divided into a first cleaning gas passage 68A relevant to the first subsystem 70 and a second cleaning gas passage 68B relevant to the second subsystem 72.

Regarding the first subsystem 70, a proximal end of the gas passage 68A is connected to a Cl₂ gas source 74 for storing the Cl₂ gas (first cleaning gas). A flow controller 76 (e.g. mass flow controller) and open-close valves 78, 78 are arranged in the gas passage 68A.

Similarly, regarding the second subsystem 72, a proximal end of the gas passage 68B is connected to a ClF₃ gas source 80 for storing the ClF₃ gas (second cleaning gas). A flow controller 82 (e.g. mass flow controller) and open-close valves 84, 84 are arranged in the gas passage 68B.

The above two kinds of cleaning gases are selectively introduced into the vessel 8 at the cleaning process, which will be described in detail later. The Cl₂ gas is used for removing alkaline earth metals, such as Ba and Sr, and the ClF₃ gas is used for removing Ti (titanium).

When the gas (Cl₂ gas or ClF₃ gas) is supplied through the nozzle 44 or 66, it rises in the processing space S in the inner tube 4 and subsequently turns down at the ceiling of the vessel 8. Thereafter, the gas falls downward in a clearance between the inner tube 4 and the outer tube 6, and is finally discharged from the processing vessel 8.

In Fig. 1, reference numeral 90 denotes a sealing member, such as 0-ring, for sealing between the cap 12 and the manifold 26, and reference numeral 92 denotes a sealing member, such as 0-ring, for sealing between the manifold 26 and the lowermost end of the outer tube 6.

Next, the film deposition process and the subsequently executed cleaning process, both of which are performed by the above-mentioned processing apparatus, will be described.

First, the film deposition process will be described. A number of semiconductor wafers (not processed) W are carried by the wafer boat 10 at regular intervals in multistage. The wafer boat 10 is mounted on the table 18 via the heat insulating tube 20. Next, the wafer boat 10 is inserted into the processing vessel 6 and the vessel 6 is closed up, upon upward movement of the arm 24 of the boat elevator 22.

The processing vessel 8 is heated in advance. After the insertion of the wafers W, a voltage of power to the heater 38 is raised thereby to raise a temperature of the wafers W to a designated processing temperature, and the processing vessel 8 is evacuated by means of a vacuum exhausting system 34.

Next, oxygen gas and film deposition gas are introduced into the processing vessel 8 through the nozzle 44 of the processing gas supplying system 40, while the respective flow rate of the oxygen gas and film deposition gas are controlled. As a matter of course, the cleaning gas is not supplied during the film deposition process.

The film deposition gas introduced into the processing vessel 8 is oxidized while it rises in the vessel 8, so that the compound metal oxide film composed of STO or BSTO is deposited on the surfaces of the wafers W. Note, this film deposition process is performed under conditions ranging from 400 to 500 °C in temperature of the wafers W and also the order of hundreds Pa of pressure.

After completing the film deposition process of a predetermined period, the valve 50 and the valve 62 of the process gas supplying system 40 are together closed to stop the supply of both processing gas and oxygen gas, completing the film deposition process.

Next, the interior of the processing vessel 8 is purged by supplying N₂ gas by means of a not-shown gas supply system, and pressure in the vessel 8 is recovered to a normal pressure. Then, the wafer boat 10 carrying the processed wafers W is unloaded out of the processing vessel 8, upon operation of the boat elevator 22. The processed wafers W are removed from the wafer boat 10, and are received in a not-shown wafer carrier.

Next, the cleaning process for removing unnecessary compound metal oxide film deposited, during the film deposition process, on the inner surface of the processing vessel 8 and the wafer boat 10 etc. will be described.

In case of cleaning the wafer boat 10 together with the processing vessel 8, the vacant wafer boat 10 holding no wafers is mounted on the heat insulating cylinder 20. Then, the wafer boat 10 is loaded into the vessel 8, and the lowermost opening of the vessel 8 is closed up air-tightly by the cap 12. In case of not cleaning the wafer boat 10, it is removed from the heat insulating cylinder 20.

First, a first cleaning step using Cl₂ gas is executed as follows. The processing vessel 8 and the interior thereof are kept at a temperature within a range from 500 to 900 °C, preferably, 700 to 900 °C. The interior of the vessel 8 is kept at a pressure within a range from 1 kPa (7.7 Torr) to 80 kPa (615 Torr), preferably, 10 kPa to 55 kPa. Upon closing the valves 84 of the second subsystem 72 while opening the valves 78 of the first subsystem 70, the Cl₂ gas under flow control is fed into the processing vessel 8 for a predetermined period.

Consequently, Ba and Sr as the alkaline earth metals included in the BSTO film react with the Cl₂ gas, thereby chlorinated compounds of Ba and Sr are produced. Under the above process condition, the compounds are vaporized and are removed from the film deposited on the surfaces of the processing vessel 8 and the wafer boat 10.

In case of the STO film without Ba, only Sr is chlorinated and removed from the film. Both Ba and Sr are the alkaline earth metals, they are of substantially identical behavior in their chemical reactions.

After completion of the first cleaning step, the second cleaning step using the ClF₃ gas is executed as follows.

Upon closing the valves 78 of the first subsystem 70, supply of the Cl₂ gas is stopped, and the interior of the processing vessel 8 is purged. The processing vessel 8 and the interior thereof are kept at a temperature within a range from 300 to 700 °C, preferably, 300 to 500 °C. The interior of the vessel 8 is kept at a pressure within a range from 0.1 kPa (0.7 Torr) to 54 kPa (415 Torr), preferably, 1 kPa to 25 kPa. Then, upon opening the valves 84 in the second subsystem 72, the ClF₃ gas under flow control is fed into the processing vessel 8 for a predetermined period.

Consequently, Ti remained in the film, from which Sr (and Ba) has been removed, reacts with the ClF₃ gas, thereby chlorinated compound(s) of Ti is produced. Under the above process condition, the compound(s) is vaporized and is removed from the film deposited on the surfaces of the processing vessel 8 and the wafer boat 10.

After completion of the first and the second cleaning step, all metals contained in the film, that is, Ba, Sr and Ti (in the BSTO film), or Sr and Ti (in the STO film) are removed, the unnecessary compound metal oxide film can be removed substantially perfectly. According to the above processes, the processing vessel 8 made of quartz, the wafer boat 10 and the heat insulating cylinder 20 are not damaged.

It should be noted that, if necessary, an inert gas (N₂, Ar, He, etc.) may be used as a carrier gas, for supplying the cleaning gases in the first and the second cleaning steps.

In the above description, the first cleaning step to remove Sr, Ba by the Cl₂ gas precedes the second cleaning step to remove Ti by the ClF₃ gas. In the modification, this order may be reversed, in other words, the second cleaning step employing the ClF₃ gas may be carried out prior to the first cleaning step employing the Cl₂ gas. However, in such a case, it should be noted that there is possibility of producing a residue of fluoride resulting from reacting of the ClF₃ gas with the elements Ba and Sr, that would be hardly removed by the sequent flowing of Cl₂ gas. From this point of view, it is preferable to carry out the first cleaning step employing the Cl₂ gas prior to the second cleaning step employing the ClF₃ gas.

Now, we describe our study and estimation about the influence of ClF₃ gas and Cl₂ gas as the cleaning gases on the elements Sr and Ti in the compound metal oxide film and also the quartz structures, such as the processing vessel. Note, upon confirmation that the element Ba exhibits a chemical behavior similar to that of the element Sr, it is found that the residual weight of Ba is generally equal to that of Sr.

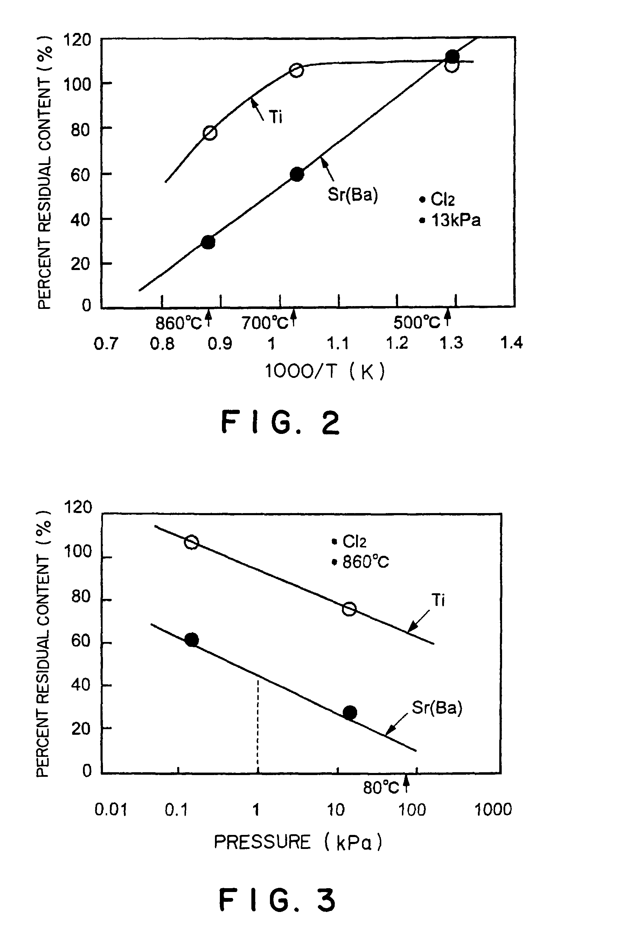

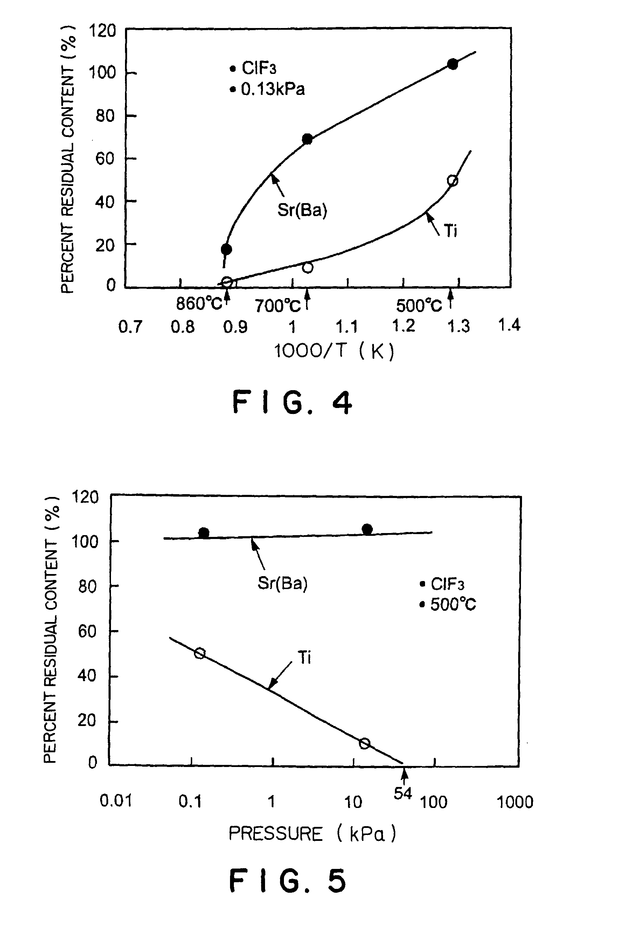

Results of the experiment are shown in Figs. 2 to 6. Fig. 2 is a graph showing temperature dependence of respective removed amounts of Ti and Sr, when Cl₂ gas is used as the cleaning gas. Fig. 4 is a graph showing temperature dependence of respective removed amounts of Ti and Sr, when ClF₃ gas is used as the cleaning gas. Fig. 3 is a graph showing pressure dependence of respective removed amounts of Ti and Sr, when Cl₂-gas is used as the cleaning gas. Fig. 5 is a graph showing pressure dependence of respective removed amounts of Ti and Sr, when ClF₃ gas is used as the cleaning gas. Note, in each of the graphs, the vertical axis designates "percent residual content", i.e., percent of "weight of one element included in the film after cleaning" relatively to "initial weight of the element included in the film before cleaning". The weight of the element included in the film was measured by means of ICP-AES (inductive plasma atomic emission microscopy). In common with Figs. 2 and 4, the horizontal axis designates 1000/T, where T is an absolute temperature of a testpiece. In the experiments related Figs. 2 to 5, each of the testpieces used is made by depositing a STO film on a substrate made of quartz.

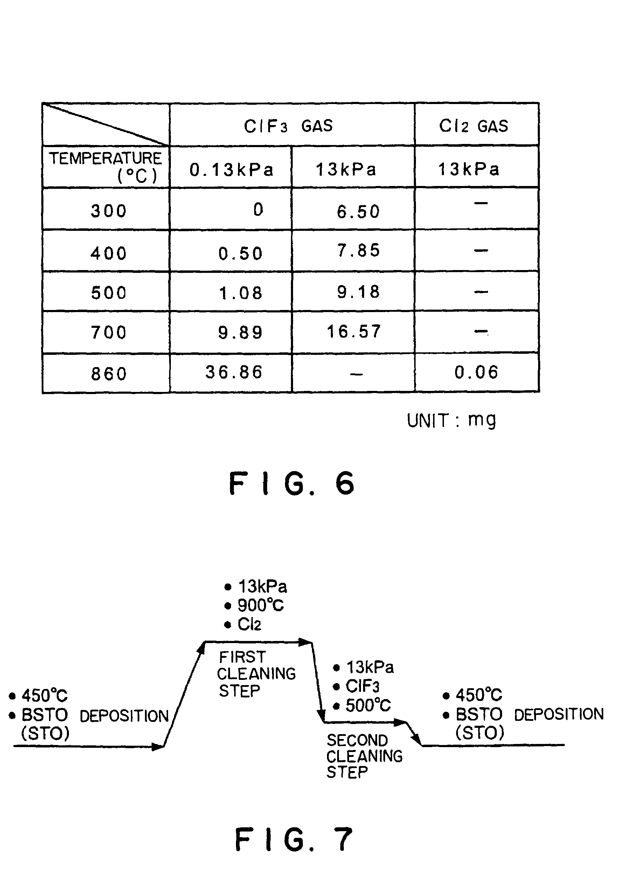

Fig. 6 is a diagram showing the degree of damage on quartz with respect to the cleaning conditions. In the experiment related Figs. 6, testpieces used are quartz pieces without any films thereon. In Fig. 6, weight reduction of the quartz testpiece of predetermined weight due to the exposure to the cleaning gas is represented by the unit of "mg".

As shown in Fig. 2, when using the Cl₂ gas, Sr (Ba) was not substantially removed at 500 °C (the percent residual content is about 100 %). While, the percent residual content of Sr (Ba) was gradually reduced as rising the temperature from 500 to 860 °C. Particularly, at 860 °C, the percent residual content of Sr (Ba) is approx. 30 %. Fig. 2 illustrates that, when Cl₂ gas is employed as the cleaning gas, the higher the temperature is raised, the more effectively Sr (Ba) is removed. Note, the process pressure was 13 kPa.

On the contrary, the percent residual content of Ti was within a range from 100 to 80 % at temperatures from 500 to 860 °C. It was found that the Cl₂ gas is not able to perform its cleaning ability to Ti. Fig. 2 also shows that the cleaning effect to Ti is not expected at even 900 °C. It should be noted that, as shown in Fig. 6, the weight reduction of the quartz was remarkably small (0.06 mg) when cleaning process was carried out employing Cl₂ gas and under conditions of 13 kPa in pressure and 860°C in temperature. Therefore, it was found that the quartz testpiece was sustained substantially no damage.

Referring to Fig. 3, when Cl₂ gas was employed as the cleaning gas, the percent residual content of Ti was only changed from 100 to 80 % upon changing the pressure from 0.1 to 13 kPa. The cleaning temperature was 860 °C. Upon considering the results shown in Figs. 2 and 3, it was found that the Cl₂ gas is not effective to remove Ti.

On the contrary, when changing the pressure from 0.13 kPa to 13 kPa, then the percent residual content of Sr (Ba) greatly changes from approx. 60 % to approx. 30 %, in other words, the cleaning efficiency was improved remarkably.

Referring to the result shown in Fig. 3, it was found that if it is desired that the percent residual content of Sr (Ba) is less than approx. 40 %, the pressure should be more than 1 kPa. Note, upon consideration of the operable pressure of the conventional processing apparatus of this kind, the upper limit of the pressure is approx. 80 kPa (615 Torr).

With respect to the above, it was found that to raise the pressure and also the temperature as possible is advantageous to remove the element Sr (Ba) by the Cl₂ gas.

As shown in Fig. 4, when using the ClF₃ gas, the percent residual content of Ti was 50 % at 500 °C. Further, the percent residual content of Ti was remarkably reduced as rising the temperature from 500 to 860 °C. Particularly, the percent residual content of Ti were approx. 10 % at 700 °C, and approx. 0 % at 860 °C, respectively. Thus, it was found that, the higher the temperature is raised, the more effectively the ClF₃ gas removes Ti. According to another experiment (not shown), it was found that the ClF₃ gas at even 300 °C is capable of removing Ti sufficiently.

On the contrary, Sr (Ba) was substantially not removed at 500 °C (the percent residual content was about 100 %). At the temperature of 700 °C, a small quantity of element Ti is removed with the percent residual content of about 70 %. Further, it may appear that the cleaning is carried out effectively because of the reduction of the percent residual content to approx. 20 % at the temperature of 860 °C. In fact, however, the quartz is seriously damaged at 860 °C (see Fig. 6). Upon inspection of the testpiece, it was found that the compound metal oxide film was peeled off together with the surface of the quartz substrate, therefore the percent residual content was remarkably reduced. That is, it was found that the ClF₃ gas is not capable of removing Sr (Ba) from the compound metal oxide film effectively, and therefore the ClF₃ gas is not so effective as the cleaning gas for removing Sr (Ba).

Referring to Fig. 5, when ClF₃ gas was employed as the cleaning gas, the percent residual content was not substantially changed and was approx. 100 %, in spite of the pressure being changed from 0.1 to 13 kPa, while the temperature being set at 500 °C. Referring the results shown in Figs. 4 and 5, it was found that the ClF₃ gas is not able to remove Ti at all.

On the contrary, upon changing the pressure to the element Ti from 0.13 kPa to 13 kPa, the percent residual content greatly changes from approx. 50 % to approx. 10 %, improving the cleaning efficiency remarkably. Fig. 5 represents that the percent residual content reduced to approx. 0 % at the pressure of 54 kPa.

Consequently, it is suggested in Figs. 4 and 5 that it is advantageous to raise the pressure and also the temperature as possible, in order to remove Ti by the ClF₃ gas. However, as obvious from Fig. 6, it causes a serious damage on the quartz to raise both temperature and pressure excessively.

Particularly, at the pressure of 0.13 kPa and the temperature of 860 °C, the weight reduction of the quartz was 36.86 mg, disadvantageously. Accordingly, if the weight reduction of the quartz is set to approx. 10 mg in its upper limit, the allowable temperature ranges from 300 to 700 °C at the pressure of 0.13 kPa, and also ranges from 300 to 500 °C at the pressure of 13 kPa. Therefore, it was found that the upper limit of temperature is approx. 700 °C although it depends on the pressure.

An example of the operation procedure of the processing apparatus 2 including the cleaning process according to the present invention will be described referring to Fig. 7. BSTO or STO film is formed on wafers W at process temperature of 450 °C. After the film deposition process has been carried out for a plurality of times, BSTO or STO film is deposited on the processing vessel 8. Then the cleaning process is carried out. In the cleaning process, the first cleaning step is carried out at 900 °C employing Cl₂-gas, and then the second cleaning step is carried out at 500 °C employing ClF₃ gas. After completion of the cleaning, the film deposition process of BSTO or STO film is started again.

In the modification of the procedure shown in Fig. 7, the above-mentioned two cleaning steps may be executed at substantially the same temperature in order to shorten the cleaning period. In addition, the film deposition process may be carried out at the same temperature as that of the cleaning processes, for example, 500 °C.

The compound metal oxide film to be cleaned by the method of the present invention is not limited to the BSTO ant STO film, and may be, for example, SBTO (SrBi₂Ta₂O₉) film, SRO (SrRuO₃) film, LSCO (La₁₋ₓSrₓCoO₃) film, etc. In these cases, while using the cleaning gases suitable to respective metals contained in the respective films, there would be carried out a cleaning process where the plural cleaning gases on selection are supplied to remove the corresponding metals successively and selectively, as similar to the above-mentioned embodiment.

Additionally, the present invention is also applicable to clean a compound metal oxide film using three or more kinds of metals of different groups in a periodic table of the elements. In such a case, it has only to let three or more kinds of cleaning gases flow successively and selectively, as occasion demands.

The present invention has been described while taking example by the batch-type processing apparatus capable of processing a plurality of wafers at a time once. Of course, the present invention is applicable to a single wafer processing apparatus for processing the wafers one by one.

As to the object(s) to be processed, it is not limited to a semiconductor wafer(s) only. Of course, the present invention is also applicable to process LCD-substrates, glass substrates, etc.

In the above description, the term "cleaning" is used, however, "cleaning" the compound metal oxide film is none other than "etching" the same. Therefore, the above-mentioned cleaning method is applicable to the etching process, in which the compound metal oxide film deposited on the substrate is etched.

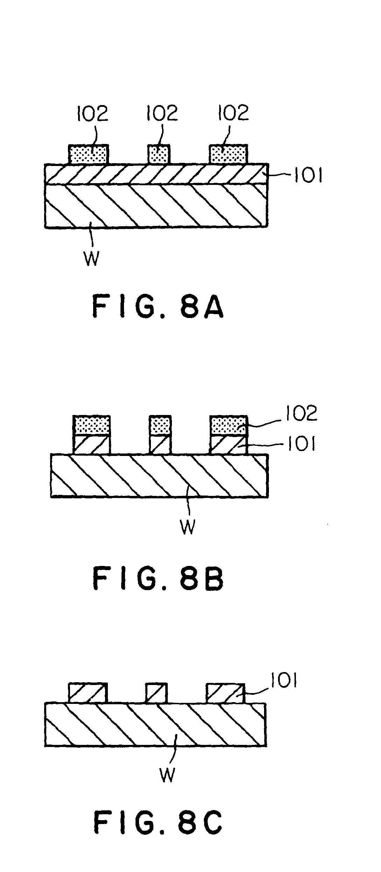

Fig. 8 shows parts of the processing steps included in the semiconductor device manufacturing process.

As shown in Fig. 8A, a compound metal oxide film 101 is deposited on the wafer W.

Next, as shown in Fig. 8B, a mask 102 with a predetermined pattern is formed on the film 101. The mask 102 may be formed of any material with corrosion resistance to Cl₂ gas and ClF₃ gas, such as a silicon oxide or a photoresist. Next, a first etching step employing Cl₂ gas and then a second etching step employing ClF₃ gas are carried out. Next, the mask 102 is removed (see Fig. 8C). The etching conditions for the first and the second etching steps may be the same as those for the above-mentioned first and the second cleaning steps, respectively.

With respect to the above, it is obvious for those skilled in the art that the apparatus shown in Fig. 1 can be used not only for film deposition but also for etching a film deposited on the substrate.

## Claims

1. A method of etching a compound metal oxide film containing a plurality of kinds of metallic elements, said method comprising the steps of:
(i) supplying a first etching gas to the film in order to remove at least one of the metallic elements from the film;
(ii) supplying a second etching gas to the film in order to remove at least one of the metallic elements other than the at least one of the metallic elements to be removed in the step (i).

2. The method according to claim 1,
wherein the at least one of the metallic elements to be removed in the step (i) is alkaline earth metal and the first etching gas is Cl₂ gas, and
wherein the at least one of the metallic elements to be removed in the step (ii) is a metal other than the alkaline earth metal, and the second etching gas is ClF₃ gas.

3. The method according to claim 2, wherein the step (ii) is carried out after completion of the step (i).

4. The method according to claim 2, wherein the step (i) is carried out after completion of the step (ii).

5. The method according to claim 2, wherein the compound metal oxide film is an STO film containing Sr as the alkaline earth metal and Ti as the metal other than the alkaline earth metal.

6. The method according to claim 2, wherein the compound metal oxide film is a BSTO film containing Ba and Sr as the alkaline earth metal and Ti as the metal other than the alkaline earth metal.

7. The method according to claim 2, wherein the compound metal oxide film contains at least one of Ba and Sr as the alkaline earth metal, and Ti as the metal other than the alkaline earth metal.

8. The method according to claim 7, wherein a process temperature in the step (i) is within a range from 500 °C to 900 °C, and a process temperature in the step (ii) is within a range from 300 °C to 700 °C.

9. The method according to claim 7, wherein a process pressure in the step (i) is within a range from 1 kPa (7.7 Torr) to 80 kPa (615 Torr), and a process pressure in the step (ii) is within a range from 0.1 kPa (0.7 Torr) to 54 kPa (415 Torr).

10. The method according to claim 7,
wherein a process temperature in the step (i) is within a range from 500 °C to 900 °C, and a process temperature in the step (ii) is within a range from 300 °C to 700 °C, and
wherein a process pressure in the step (i) is within a range from 1 kPa (7.7 Torr) to 80 kPa (615 Torr), and a process pressure in the step (ii) is within a range from 0.1 kPa (0.7 Torr) to 54 kPa (415 Torr).

11. The method according to claim 2, wherein the compound metal oxide film to be etched by said etching method is a compound metal oxide film deposited on a surface of a component of a processing apparatus for film deposition, and said etching method is carried out for the purpose of cleaning the component.

12. The method according to claim 2, wherein the compound metal oxide film to be etched by said etching method is a compound metal oxide film deposited on a surface of a substrate, such as a semiconductor wafer, an LCD substrate or the like.

13. A processing apparatus for film deposition comprising:
a processing vessel defining a processing space, in which an object is subjected to a film deposition process;
a film deposition gas supply system that supplies a film deposition gas into the processing vessel; and
a cleaning gas supply system including:
a first subsystem that supplies a first cleaning gas into the processing vessel; and
a second subsystem that supplies a second cleaning gas into the processing vessel,
wherein the cleaning gas supply system is capable of supplying the first and the second cleaning gases selectively.

14. The processing apparatus according to claim 13, wherein the first cleaning gas is Cl₂ gas and the second cleaning gas is ClF₃ gas.

15. An etching apparatus comprising:
a processing vessel defining a processing space, in which an object is subjected to an etching process;
an etching gas supply system including:
a first subsystem that supplies a first etching gas into the processing vessel; and
a second subsystem that supplies a second etching gas into the processing vessel,
wherein the etching gas supply system is capable of supplying the first and the second etching gases selectively.

16. The processing apparatus according to claim 15, wherein the first etching gas is Cl₂ gas and the second etching gas is ClF₃ gas.
